# EUROPEAN PATENT SPECIFICATION

(11) **EP 2 919 480 B1**
(45) Date of publication and mention of the grant of the patent: **21.09.2016**
(21) Application number: 14158474.8
(22) Date of filing: 10.03.2014
(51) Int. Cl.: H04Q 1/06, H05K 7/14

(54) **CABLE MANAGEMENT ARM ASSEMBLY**
ANORDNUNG ZUR KABELVERWALTUNG BESTEHEND AUS MEHREREN KABELFÜHRUNGSARMEN
ENSEMBLE DE BRAS DE GESTION DE CÂBLES

(43) Date of publication of application: 16.09.2015
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Fang, Chiang-Hsueh, Kaohsiung City (TW); Wang, Chun-Chiang, Kaohsiung City (TW)
(74) Representative: Viering, Jentschura & Partner mbB Patent- und Rechtsanwälte

(56) References cited:
- US-A1- 2009 078 834
- US-B2- 8 251 321

## Description

### Field of the Invention

The present invention relates to a cable management arm assembly and more particularly to a supporting structure for cable management.

### Background of the Invention

The supporting structure of cable management arms has been disclosed in US Patent No. 7,472,795 B2, granted to Dubon et al.; US Patent No. 7,654,398 B2, granted to Bridges et al.; US Patent No. 7,746,667 B1, granted to Baiza et al.; and US Patent Nos. 7,554,819 B2; 7,712,615 B2; 8,231,014 B2; and 8,251,321 B2, granted to Chen et al.

However, the foregoing supporting structures for cable management arms leave room for improvement especially in terms of the convenience of installation and use. In view of this, the inventor of the present invention envisioned designing a more simple supporting structure.

### Summary of the Invention

The present invention relates to a cable management arm assembly. More particularly, the present invention relates to a structurally simple design for holding, managing, and securely supporting cables.

According to one aspect of the present invention, a cable management arm assembly includes: a first arm; a second arm; a cable base pivotally connected between the first arm and the second arm; a plate fixedly connected to the bottom of the cable base; a supporting base; a first connecting unit connected to the first arm; a second connecting unit connected to the second arm; a third connecting unit connected to the supporting base; a first supporting member pivotally connected to the supporting base and abutting against the supporting base; a second supporting member movably connected to the first supporting member and extensible/retractable relative to the first supporting member; and a sliding base connected to the plate and movably connected to the second supporting member. The first arm is mounted at a fixed first predetermined position via the first connecting unit. The second arm is mounted at a variable second predetermined position via the second connecting unit. The supporting base is mounted at a fixed third predetermined position via the third connecting unit. When the second connecting unit of the second arm is displaced away from the first connecting unit of the first arm, the cable base is moved away from the supporting base due to the sliding base sliding on the second supporting member, and the sliding base drives the second supporting member to extend relative to the first supporting member and drives the first supporting member to rotate relative to the supporting base.

Preferably, the cable management arm assembly further includes an elastic element connected between the first supporting member and the second supporting member so that the second supporting member can be elastically pulled relative to the first supporting member by the elastic element.

Preferably, the second supporting member has a first stop block and a second stop block, both corresponding in position to the sliding base so that the sliding base can slide between the first stop block and the second stop block. Once stopped at the first stop block, the sliding base drives the second supporting member to displace relative to the first supporting member.

Preferably, the first supporting member has a first hook, the second supporting member has a second hook, and the elastic element is connected to the first hook and the second hook.

Preferably, the supporting base has a first supporting portion and a second supporting portion substantially perpendicular to the first supporting portion. The third connecting unit is pivotally connected to the first supporting portion, and the first supporting member is pivotally connected to the second supporting portion.

Preferably, the first supporting portion of the supporting base has a first projection and a second projection, and the third connecting unit has a first positioning hole and a second positioning hole. When the third connecting unit is rotated in a first direction relative to the supporting base to a first position, the first projection of the third connecting unit is engaged in the first positioning hole such that the third connecting unit is fixed in position. When the third connecting unit is rotated in a second direction relative to the supporting base to a second position, the second projection of the third connecting unit is engaged in the second positioning hole such that the third connecting unit is fixed in position.

Preferably, the plate has a curved sliding groove, and the sliding base is connected to the curved sliding groove via a first connecting element so as to rotate relative to the plate in a limited manner.

Preferably, the cable management arm assembly further includes: a first slide rail assembly at least including a first fixed rail and a first movable rail longitudinally and slidably displaceable relative to the first fixed rail; and a second slide rail assembly at least including a second fixed rail and a second movable rail longitudinally and slidably displaceable relative to the second fixed rail. The first connecting unit is mounted on the first fixed rail of the first slide rail assembly and is thereby fixed at the first predetermined position. The second connecting unit is mounted on the first movable rail of the first slide rail assembly and is thus located at the second predetermined position, wherein the second predetermined position is variable in response to sliding of the first movable rail relative to the first fixed rail. The third connecting unit is mounted on the second fixed rail of the second slide rail assembly and is thereby fixed at the third predetermined position.

According to another aspect of the present invention, a cable management system of the present invention includes a first slide rail assembly, a second slide rail assembly, a first arm, a second arm, a cable base, a supporting base, a first supporting member, a second supporting member, an elastic element, and a sliding base. The first slide rail assembly at least includes a first fixed rail and a first movable rail. The first movable rail can be longitudinally and slidably displaced relative to the first fixed rail. The second slide rail assembly at least includes a second fixed rail and a second movable rail. The second movable rail can be longitudinally and slidably displaced relative to the second fixed rail. The first arm is connected to the first fixed rail of the first slide rail assembly. The second arm is connected to the first movable rail of the first slide rail assembly. The cable base is pivotally connected between the first arm and the second arm. The supporting base is connected to the second fixed rail of the second slide rail assembly. The first supporting member is pivotally connected to the supporting base and abuts against the supporting base. The second supporting member is slidably connected to the first supporting member. The elastic element is connected between the first supporting member and the second supporting member. The sliding base is pivotally connected to the cable base and is slidably connected to the second supporting member. When the first slide rail assembly and the second slide rail assembly are extended, the second arm is displaced away from the first arm, the sliding base moves away from the supporting base by sliding on the second supporting member, and the sliding base drives the second supporting member to extend from the first supporting member and drives the first supporting member to rotate relative to the supporting base. When the first slide rail assembly and the second slide rail assembly are retracted, the second arm is brought close to the first arm, and the second supporting member is displaced relative to the first supporting member in response to the elastic force generated by the elastic element.

### Brief Description of the Drawings

The invention as well as a preferred mode of use and the advantages thereof will be best understood by referring to the following detailed description of some illustrative embodiments in conjunction with the accompanying drawings, wherein:
FIG. 1 is an exploded perspective view of an embodiment of the present invention;
FIG. 2 is a partial view of the embodiment depicted in FIG. 1;
FIG. 3 is a schematic drawing in which the cable management arm assembly in the embodiment depicted in FIG. 1 is in a closed position;
FIG. 4 is a schematic drawing in which the second connecting unit of the second arm in the embodiment depicted in FIG. 1 is spaced apart from the first connecting unit of the first arm by a first distance;
FIG. 5 is a schematic drawing in which the second connecting unit of the second arm in the embodiment depicted in FIG. 1 is spaced apart from the first connecting unit of the first arm by a second distance;
FIG. 6 is a schematic drawing in which the second connecting unit of the second arm in the embodiment depicted in FIG. 1 is spaced apart from the first connecting unit of the first arm by a third distance;
FIG. 7 is a schematic drawing in which the second connecting unit of the second arm in the embodiment depicted in FIG. 1 is spaced apart from the first connecting unit of the first arm by a fourth distance;
FIG. 8 is a schematic drawing in which the third connecting unit in the embodiment depicted in FIG. 1 is connected to the second movable rail of the second slide rail assembly; and
FIG. 9 shows that the third connecting unit in the embodiment depicted in FIG. 1 can be switched between different positions relative to the supporting base.

### Detailed Description of the Invention

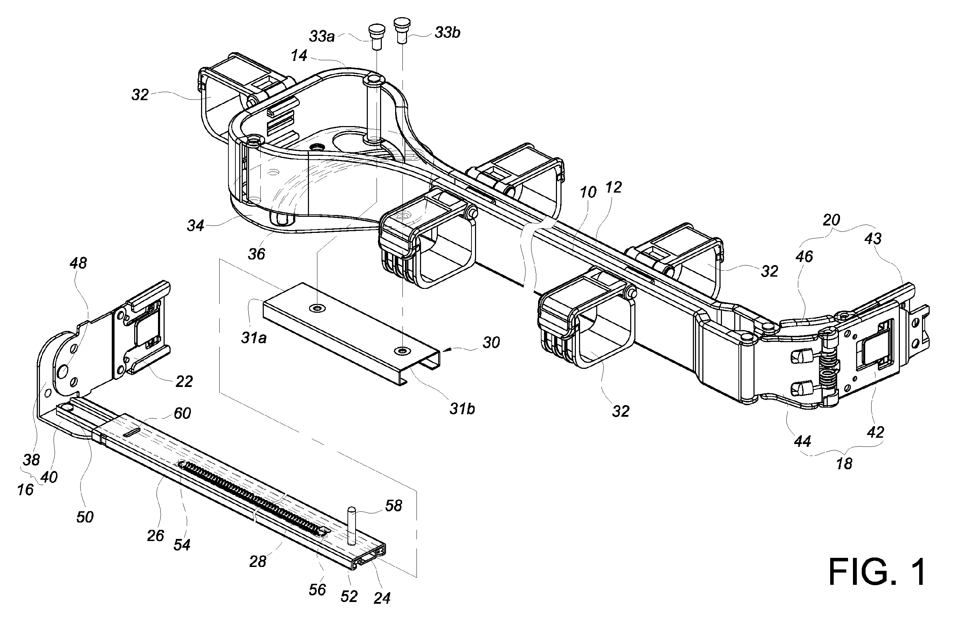

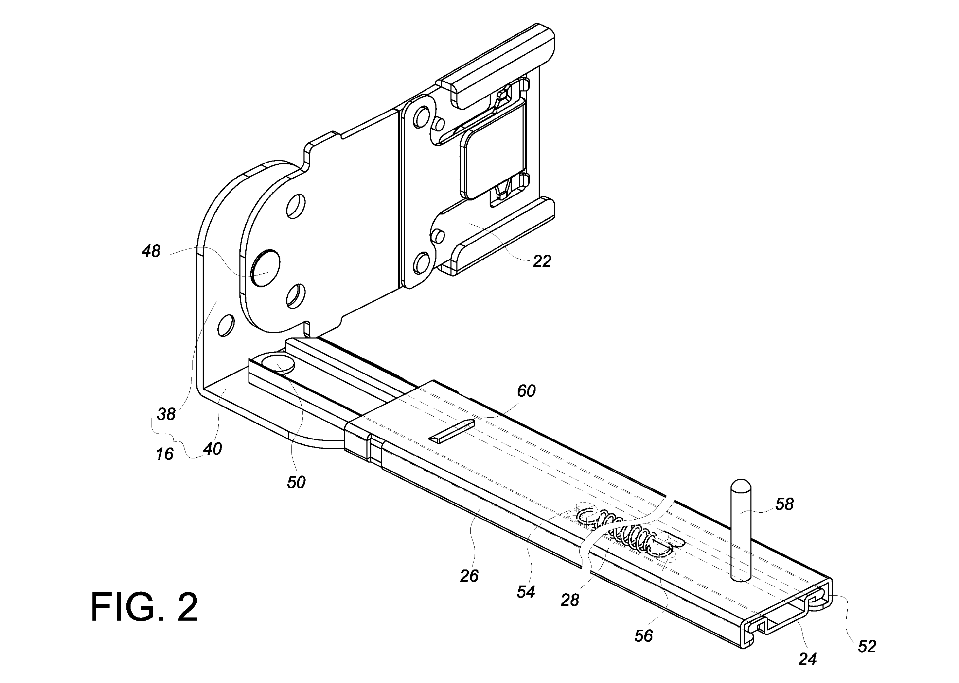

As shown in FIG. 1 and FIG. 2, the cable management arm assembly in one embodiment of the present invention includes a first arm 10, a second arm 12, a cable base 14, a supporting base 16, a first connecting unit 18, a second connecting unit 20, a third connecting unit 22, a first supporting member 24, a second supporting member 26, an elastic element 28, a sliding base 30, and a plurality of cable holders 32. The cable holders 32 are configured for holding cables (not shown) and are provided on the first arm 10, the second arm 12, and the cable base 14.

The cable base 14 is pivotally connected between the first arm 10 and the second arm 12. The cable base 14 includes a plate 34. In one preferred embodiment, the plate 34 is a separate component fixedly connected to the bottom of the cable base 14. Alternatively, the plate 34 is integrally formed with the cable base 14. Therefore, the plate 34 can be viewed as a portion of the cable base 14. In one preferred embodiment, the plate 34 has a curved sliding groove 36.

The supporting base 16 has a first supporting portion 38 and a second supporting portion 40 substantially perpendicular to the first supporting portion 38.

The first connecting unit 18 is connected to the first arm 10 and includes a first engaging base 42 and a first connecting base 44 pivotally connected to the first engaging base 42. In one preferred embodiment, the first connecting base 44 is pivotally connected to the first arm 10.

The second connecting unit 20 is connected to the second arm 12 and includes a second engaging base 43 and a second connecting base 46 pivotally connected to the second engaging base 43. In one preferred embodiment, the second connecting base 46 is pivotally connected to the second arm 12.

The third connecting unit 22 is pivotally connected to the first supporting portion 38 of the supporting base 16 via a first pivoting element 48.

The first supporting member 24 is pivotally connected to the second supporting portion 40 of the supporting base 16 via a second pivoting element 50. In addition, the first supporting member 24 abuts against the second supporting portion 40 of the supporting base 16.

The second supporting member 26 is movably connected to the first supporting member 24. More specifically, the second supporting member 26 has a channel 52, and the first supporting member 24 is disposed in the channel 52 such that the second supporting member 26 is displaceable relative to the first supporting member 24. In one preferred embodiment, the first supporting member 24 has a first hook 54, which preferably extends integrally from the first supporting member 24, and the second supporting member 26 has a second hook 56, which preferably extends integrally from the second supporting member 26. Moreover, the second supporting member 26 is provided with a first stop block 58 and a second stop block 60 at two ends respectively.

The elastic element 28 is connected to the first hook 54 of the first supporting member 24 and the second hook 56 of the second supporting member 26, so that the second supporting member 26 can be elastically pulled relative to the first supporting member 24 by the elastic element 28. In other words, the second supporting member 26 can be displaced relative to the first supporting member 24 in response to the elastic force generated by the elastic element 28. For example, the second supporting member 26 can be pulled relative to the first supporting member 24 from an extended state to a retracted state by the elastic force generated by the elastic element 28.

The sliding base 30 has a first end portion 31a and a second end portion 31b. A first connecting element 33a passes through the curved sliding groove 36 of the plate 34 and is connected adjacent to the first end portion 31a of the sliding base 30 so that the sliding base 30 can rotate relative to the plate 34 in a limited space defined by the curved sliding groove 36. Preferably, the second end portion 31b of the sliding base 30 is pivotally connected to the plate 34 via a second connecting element 33b. Further, the sliding base 30 is movably located between the first stop block 58 and the second stop block 60 of the second supporting member 26. It should be noted that, as stated above, the plate 34 can be viewed as a portion of the cable base 14, and so can the sliding base 30 connected to the cable base 14.

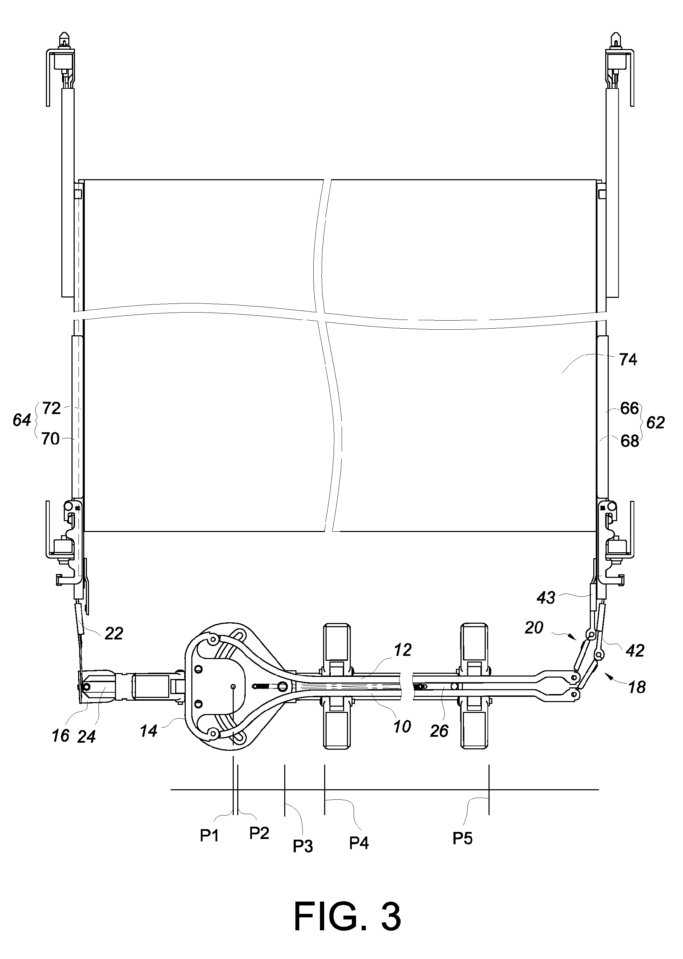

In FIG. 3, the cable management arm assembly of the present invention is mounted on a first slide rail assembly 62 and a second slide rail assembly 64, which are provided in pairs. The first slide rail assembly 62 at least includes a first fixed rail 66 and a first movable rail 68, wherein the first movable rail 68 is longitudinally and slidably displaceable relative to the first fixed rail 66. Similarly, the second slide rail assembly 64 at least includes a second fixed rail 70 and a second movable rail 72, wherein the second movable rail 72 is longitudinally and slidably displaceable relative to the second fixed rail 70. A server apparatus 74 can be mounted on the first movable rail 68 of the first slide rail assembly 62 and the second movable rail 72 of the second slide rail assembly 64 and have its cables (not shown) arranged by means of the first arm 10, the second arm 12, and the cable base 14. The first arm 10 is connected to the first fixed rail 66 of the first slide rail assembly 62 via the first engaging base 42 of the first connecting unit 18 such that one end of the first arm 10 is fixed at a first predetermined position. The second arm 12 is connected to the first movable rail 68 of the first slide rail assembly 62 via the second engaging base 43 of the second connecting unit 20 such that one end of the second arm 12 is located at a second predetermined position. The second predetermined position is variable because the first movable rail 68 of the first slide rail assembly 62 can slide relative to the first fixed rail 66. The supporting base 16 is connected to the second fixed rail 70 of the second slide rail assembly 64 via the third connecting unit 22 and is thereby fixed at a third predetermined position. When the first slide rail assembly 62 and the second slide rail assembly 64 are in the retracted state, as shown in FIG. 3, the second arm 12 and the first arm 10 are brought close to each other, forming a suspended member spanning a large distance. In this state, the center of gravity of the entire cable management arm assembly is located at P1. More specifically, the second supporting member 26 is retracted relative to the first supporting member 24, and the first supporting member 24 abuts against the supporting base 16. Therefore, when the first arm 10 and the second arm 12 are in a closed state in which they are close to each other, it is mainly the supporting base 16 that supports the cable management arm assembly; the load on the first connecting unit 18 and the second connecting unit 20 is relatively small.

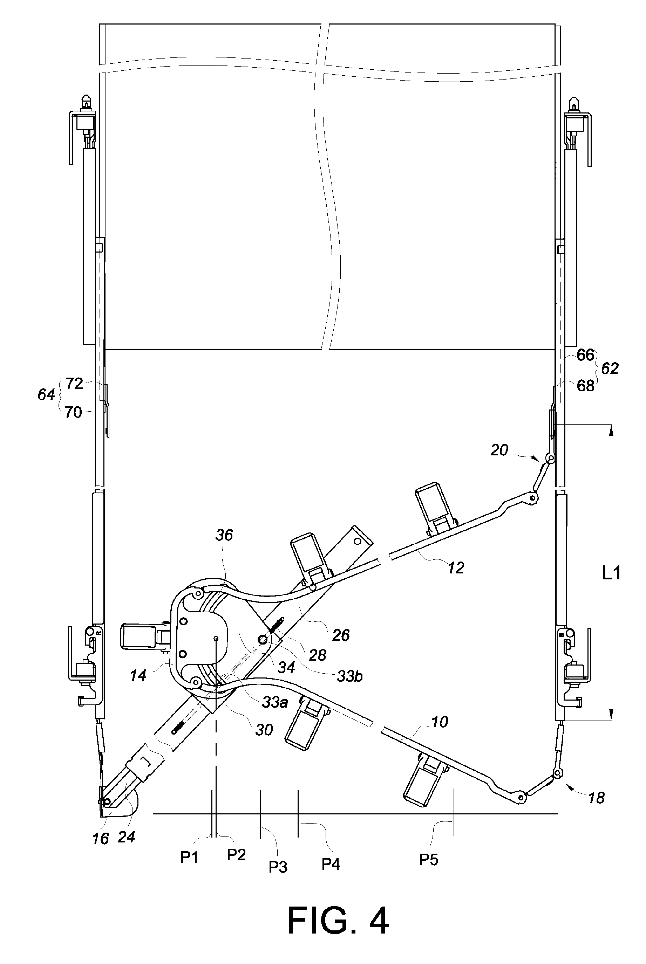

In FIG. 4, the first movable rail 68 of the first slide rail assembly 62 and the second movable rail 72 of the second slide rail assembly 64 have been pulled out preliminarily. As a result, the second connecting unit 20 of the second arm 12 is displaced relative to the first connecting unit 18 of the first arm 10 by a first distance L1. Limited by the elastic element 28, the second supporting member 26 in this state has yet to extend from the first supporting member 24. The cable base 14 and the plate 34, on the other hand, have slid linearly along the second supporting member 26 via the sliding base 30, and the cable base 14 has displaced in response to the displacement of the second arm 12. Through the sliding base 30 and the second supporting member 26, the cable base 14 has driven the first supporting member 24 to rotate relative to the supporting base 16. Meanwhile, due to the fact that the sliding base 30 is pivotally connected to the cable base 14 via the second connecting element 33b, the sliding base 30 itself has rotated relative to the cable base 14 and the plate 34 in a limited space defined by the curved sliding groove 36, thanks to the first connecting element 33a. In this state, the center of gravity of the entire cable management arm assembly is located at P2, with the supporting base 16 and the second supporting member 26 (together with the first supporting member 24) jointly providing effective support.

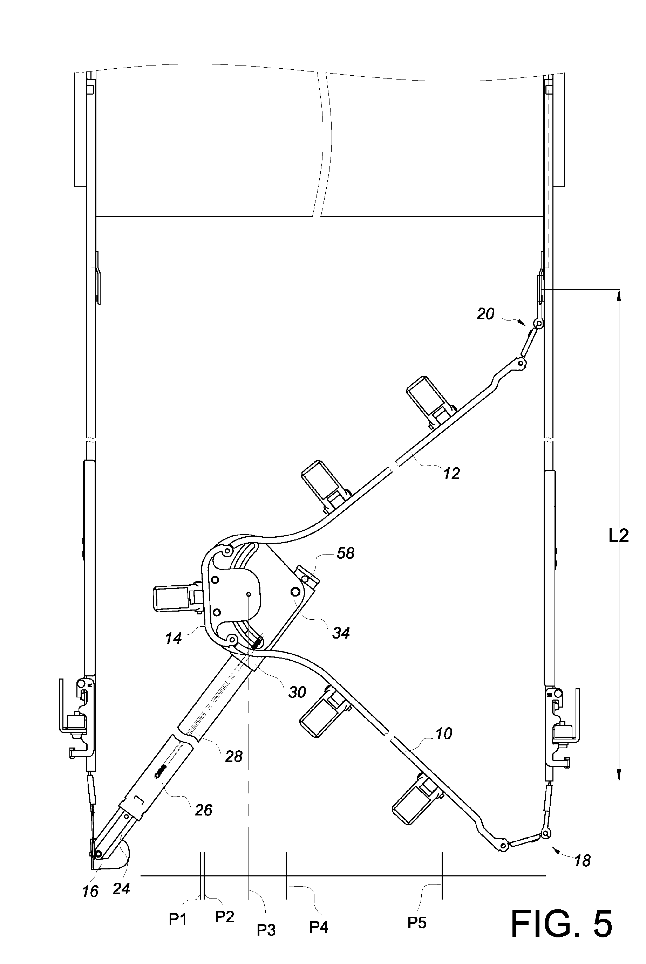

In FIG. 5, the second connecting unit 20 of the second arm 12 has been further displaced relative to the first connecting unit 18 of the first arm 10 such that the second connecting unit 20 is spaced from the first connecting unit 18 by a second distance L2. With the help of the sliding base 30, the cable base 14 and the plate 34 have slid along the second supporting member 26 to the first stop block 58, and after being stopped at the first stop block 58, the sliding base 30 has driven the second supporting member 26 to extend from the first supporting member 24 and has driven the first supporting member 24 to rotate relative to the supporting base 16. Meanwhile, the elastic element 28 is stretched by the second supporting member 26 and generates an elastic force for pulling back the second supporting member 26. The center of gravity of the entire cable management arm assembly in this state is situated at P3.

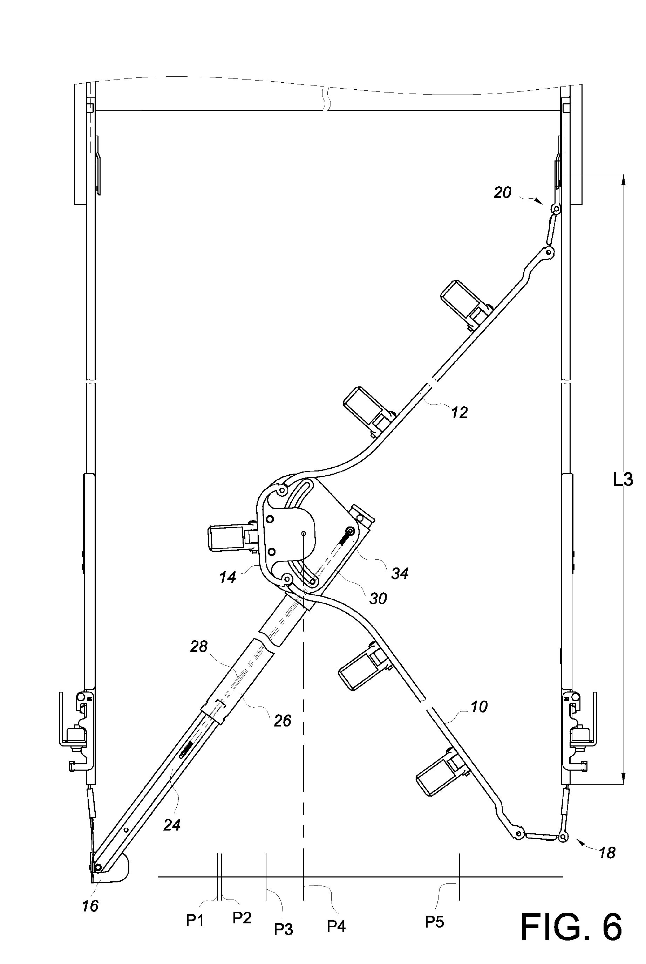

In FIG. 6, the second connecting unit 20 of the second arm 12 is spaced from the first connecting unit 18 of the first arm 10 by a third distance L3 after being further displaced relative to the first connecting unit 18. The cable base 14 and the plate 34 have, by means of the sliding base 30, driven the second supporting member 26 to extend further from the first supporting member 24 while the elastic element 28 continues applying an elastic force to the second supporting member 26. In this state, the center of gravity of the entire cable management arm assembly is located at P4, which is close to the center of the cable management arm assembly; therefore, the weight of the cable management arm assembly is jointly supported by the supporting base 16, the first connecting unit 18, and the second connecting unit 20.

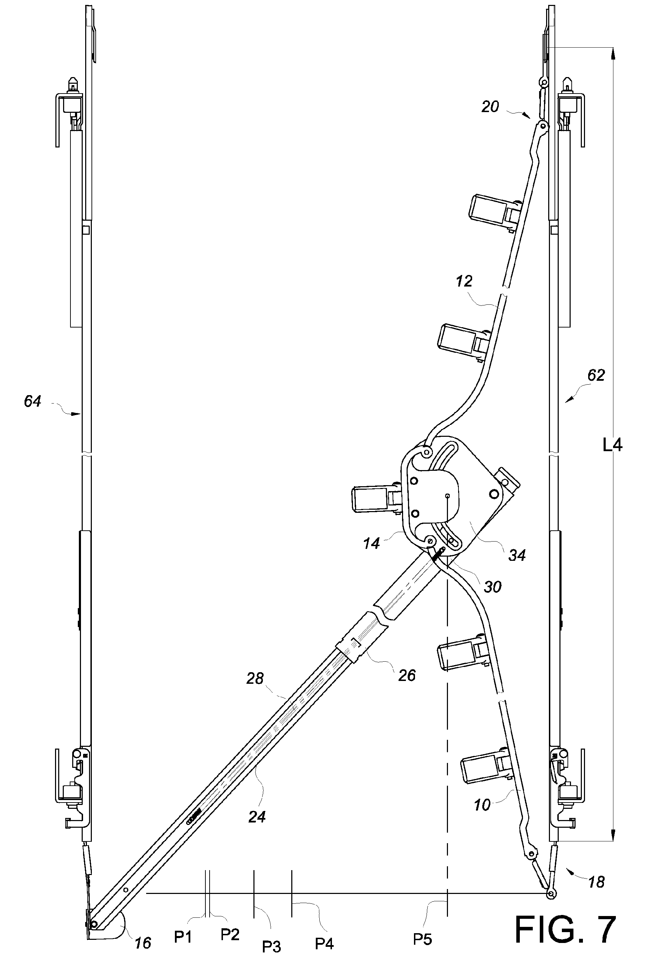

In FIG. 7, the second connecting unit 20 of the second arm 12 has been further displaced relative to the first connecting unit 18 of the first arm 10 to a fully extended position, where the second connecting unit 20 is spaced from the first connecting unit 18 by a fourth distance L4. The cable base 14 and the plate 34 have, by means of the sliding base 30, driven the second supporting member 26 to extend fully from the first supporting member 24, with the second supporting member 26 still subjected to the elastic force of the elastic element 28. In this state, the gravity center of the entire cable management arm assembly is located at P5, which is close to the first slide rail assembly 62. Consequently, most of the weight of the cable management arm assembly is jointly borne by the first connecting unit 18 and the second connecting unit 20.

It should be pointed out that, while the cable management arm assembly returns to the closed state, the second supporting member 26 is automatically pulled back relative to the first supporting member 24 due to the elastic force generated by the elastic element 28. The sliding base 30 will be displaced along the second supporting member 26 toward the supporting base 16, stop at the second stop block 60, and stay there until the second supporting member 26 is fully retracted relative to the first supporting member 24, i.e., when the cable management arm assembly is fully closed.

Apart from being pivotally connected to the plate 34 in a rotatable configuration, the sliding base 30 may be directly fixed to the plate 34 of the cable base 14, provided that the length of the first arm 10 is extensible, allowing the sliding base 30 to slide along the second supporting member 26.

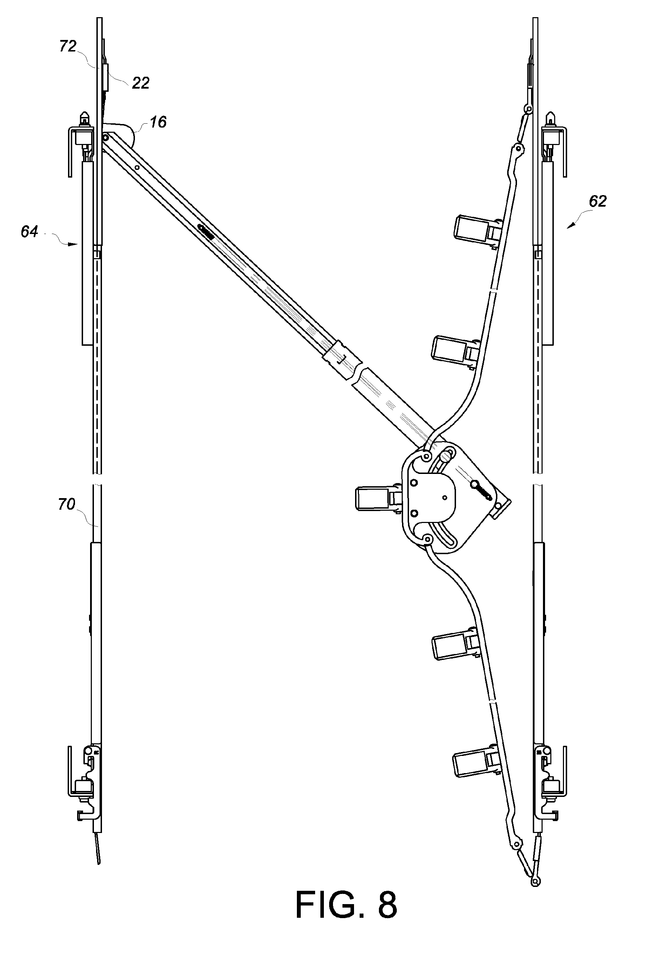

In one preferred embodiment as shown in FIG. 8, the supporting base 16 is connected to the second movable rail 72 of the second slide rail assembly 64 via the third connecting unit 22. The working principle of the cable management arm assembly in this configuration is similar to when the third connecting unit 22 is connected to the second fixed rail 70 and therefore will not be stated repeatedly.

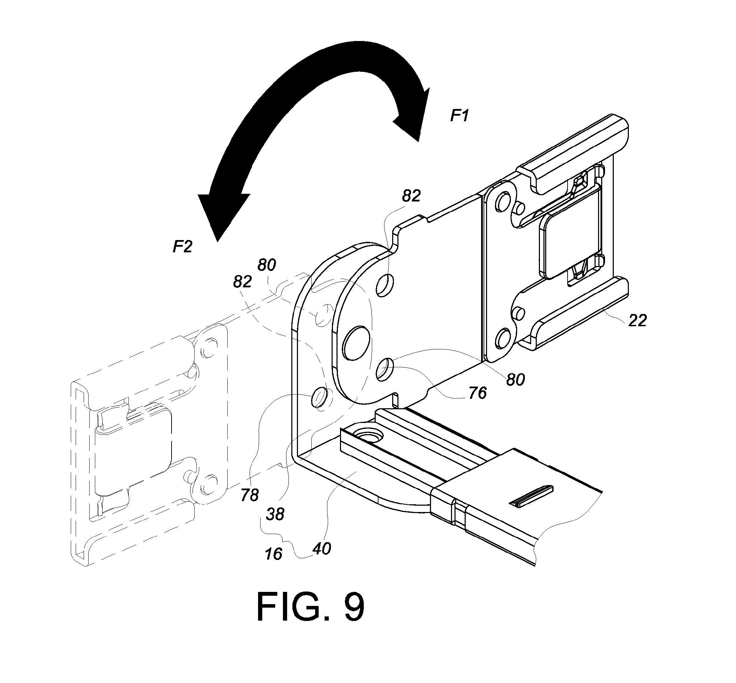

Referring to FIG. 9, the first supporting portion 38 of the supporting base 16 has a first projection 76 and a second projection 78, and the third connecting unit 22 has a first positioning hole 80 and a second positioning hole 82. When the third connecting unit 22 is rotated in a first direction F1 relative to the supporting base 16 to a first position, the first projection 76 of the third connecting unit 22 is engaged in the first positioning hole 80 to fix the third connecting unit 22 in position. When the third connecting unit 22 is rotated in a second direction F2 relative to the supporting base 16 to a second position, the second projection 78 of the third connecting unit 22 is engaged in the second positioning hole 82 to fix the third connecting unit 22 in position. This technical feature allows the cable management arm assembly to be used when laterally reversed.

As stated above, the cable management arm assembly of the present invention not only can provide stable static support when in the closed state, but also can redistribute its own weight between its components when extended to different degrees and thereby provide dynamic support. Hence, the cable management arm assembly will not sag excessively when loaded with cables.

It is understood that the preferred embodiments provided herein are intended only to demonstrate the present invention by way of example and should not be construed as restrictive of the scope of the present invention. The scope of the present invention is defined only by the appended claims.

## Claims

1. A cable management arm assembly comprising:
a first arm (10);
a second arm (12);
a cable base (14) pivotally connected between the first arm (10) and the second arm (12);
a plate (34) fixedly connected to a bottom of the cable base (14); and
a supporting base (16);
a first supporting member (24) pivotally connected to the supporting base (16) and abutting against the supporting base (16);
a second supporting member (26) movably connected to the first supporting member (24); and
a sliding base (30) connected to the plate (34) and movably connected to the second supporting member (26);
wherein when the second arm (12) is displaced away from the first arm (10), the sliding base (30) moves away from the supporting base (16) by sliding on the second supporting member (26), and the sliding base (30) drives the second supporting member (26) to extend relative to the first supporting member (24) and drives the first supporting member (24) to rotate relative to the supporting base (16); **characterized in that** the second supporting member (26) is extensible and retractable relative to the first supporting member (24), wherein an elastic element (28) is connected between the first supporting member (24) and the second supporting member (26) so that the second supporting member (26) can be elastically pulled relative to the first supporting member (24) by the elastic element (28).

2. The cable management arm assembly of claim 1, further comprising:
a first connecting unit (18) connected to the first arm (10);
a second connecting unit (20) connected to the second arm (12); and
a third connecting unit (22) connected to the supporting base (16);
wherein the first arm (10) is mounted at a fixed first predetermined position via the first connecting unit (18); the second arm (12) is mounted at a variable second predetermined position via the second connecting unit (20); and the supporting base (16) is mounted at a fixed third predetermined position via the third connecting unit (22); and
wherein when the second arm (12) is displaced away from the first arm (10), the second connecting unit (20) of the second arm (12) is displaced away from the first connecting unit (18) of the first arm (10), and the cable base (14) is moved away from the supporting base (16) due to the sliding base (30) sliding on the second supporting member (26).

3. The cable management arm assembly of claim 1 or 2, wherein the second supporting member (26) has a first stop block (58) and a second stop block (60), both said stop blocks (58, 60) corresponding in position to the sliding base (30) so that the sliding base (30) is slidable between the first stop block (58) and the second stop block (60); and the sliding base (30), once stopped at the first stop block (58), drives the second supporting member (26) to displace relative to the first supporting member (24).

4. The cable management arm assembly of claim 1, wherein the first supporting member (24) has a first hook (54), the second supporting member (26) has a second hook (56), and the elastic element (28) is connected to the first hook (54) and the second hook (56).

5. The cable management arm assembly of claim 2, wherein the supporting base (16) has a first supporting portion (38) and a second supporting portion (40) substantially perpendicular to the first supporting portion (38), the third connecting unit (22) being pivotally connected to the first supporting portion (38), the first supporting member (24) being pivotally connected to the second supporting portion (40).

6. The cable management arm assembly of claim 5, wherein the first supporting portion (38) of the supporting base (16) has a first projection (76) and a second projection (78); the third connecting unit (22) has a first positioning hole (80) and a second positioning hole (82); when the third connecting unit (22) is rotated in a first direction (F1) relative to the supporting base (16) to a first position, the first projection (76) of the third connecting unit (22) is engaged in the first positioning hole (80) to fix the third connecting unit (22) in position; and when the third connecting unit (22) is rotated in a second direction (F2) relative to the supporting base (16) to a second position, the second projection (78) of the third connecting unit (22) is engaged in the second positioning hole (82) to fix the third connecting unit (22) in position.

7. The cable management arm assembly of claim 2, wherein the plate (34) has a curved sliding groove (36), and the sliding base (30) is connected to the curved sliding groove (36) via a first connecting element (33a) so as to rotate relative to the plate (34) in a limited manner.

8. The cable management arm assembly of claim 2, further comprising:
a first slide rail assembly (62) comprising a first fixed rail (66) and a first movable rail (68) longitudinally and slidably displaceable relative to the first fixed rail (66); and
a second slide rail assembly (64) comprising a second fixed rail (70) and a second movable rail (72) longitudinally and slidably displaceable relative to the second fixed rail (70);
wherein the first connecting unit (18) is mounted on the first fixed rail (66) of the first slide rail assembly (62) to be fixed at the first predetermined position; the second connecting unit (20) is mounted on the first movable rail (68) of the first slide rail assembly (62) to be located at the second predetermined position, the second predetermined position being variable in response to sliding of the first movable rail (68) relative to the first fixed rail (66); and the third connecting unit (22) is mounted on the second fixed rail (70) of the second slide rail assembly (64) and to be fixed at the third predetermined position.

9. A cable management system comprising the cable management arm assembly according to claim 1 and further comprising:
a first slide rail assembly (62) comprising a first fixed rail (66) and a first movable rail (68), the first movable rail (68) being longitudinally slidable relative to the first fixed rail (66); and
a second slide rail assembly (64) comprising a second fixed rail (70) and a second movable rail (72), the second movable rail (72) being longitudinally slidable relative to the second fixed rail (70); **characterized in that** the cable management system further comprises an elastic element (28) connected between the first supporting member (24) and the second supporting member (26);
wherein the first arm (10) is connected to the first fixed rail (66) of the first slide rail assembly (62); the second arm (12) is connected to the first movable rail (68) of the first slide rail assembly (62); and the supporting base (16) is connected to the second fixed rail (70) of the second slide rail assembly (64);
wherein when the first slide rail assembly (62) and the second slide rail assembly (64) are extended, the second arm (12) is displaced away from the first arm (10), the sliding base (30) moves away from the supporting base (16) by sliding on the second supporting member (26), and the sliding base (30) drives the second supporting member (26) to extend relative to the first supporting member (24) and drives the first supporting member (24) to rotate relative to the supporting base (16); and
wherein when the first slide rail assembly (62) and the second slide rail assembly (64) are retracted, the second arm (12) is brought close to the first arm (10), and the second supporting member (26) is displaced relative to the first supporting member (24) in response to an elastic force generated by the elastic element (28).

## Patentansprüche

1. Ein Aufbau eines Kabelführungsarms, umfassend:
einen ersten Ann (10);
einen zweiten Arm (12);
eine Kabelbasis (14), die drehgelenkig zwischen dem ersten Arm (10) und dem zweiten Arm (12) befestigt ist;
einem Plättchen (34), das fest an einer Unterseite der Kabelbasis (14) montiert ist; und
eine tragende Basis (16);
ein erstes Trägerelement (24), das drehgelenkig an der tragenden Basis (16) befestigt ist und an diese tragende Basis (16) anstößt;
ein zweites Trägerelement (26), das verschiebbar am ersten Trägerelement (24) befestigt ist; und
einer Schiebeleiste (30), die am Plättchen (34) befestigt und verschiebbar am zweiten Trägerelement (26) montiert ist;
wobei die Schiebeleiste (30) durch Gleiten auf dem zweiten Trägerelement (26) von der tragenden Basis (16) wegbewegt wird, wenn der zweite Arm (12) vom ersten Arm (10) weggeschoben wird; die Schiebeleiste (30) das zweite Trägerelement (26) anschiebt, um dieses vom ersten Trägerelement (24) auszuziehen, und ebenfalls das erste Trägerelement (24) anschiebt, um dieses an der tragenden Basis (16) zu rotieren; **dadurch gekennzeichnet, dass** das zweite Trägerelement (26) am ersten Trägerelement (24) ausziehbar und einziehbar ist; ein Kunststoffelement (28) zwischen dem ersten Trägerelement (24) und dem zweiten Trägerelement (26) befestigt ist, um das zweite Trägerelement (26) mit diesem Kunststoffelement (28) elastisch zum ersten Trägerelement (24) zu ziehen.

2. Der Aufbau des Kabelführungsarms nach Anspruch 1, weiter umfassend:
ein erstes Verbindungsglied (18), das am ersten Arm (10) befestigt ist;
ein zweites Verbindungsglied (20), das am zweiten arm (12) befestigt ist; und
ein drittes Verbindungsglied (22), das an der tragenden Basis (16) befestigt ist;
wobei der erste Arm (10) über das erste Verbindungsglied (18) in einer festen ersten vorbestimmten Position montiert ist; der zweite Arm (12) über das zweite Verbindungsglied (20) in einer variablen zweiten vorbestimmten Position montiert ist; und die tragende Basis (16) über das dritte Verbindungsglied (22) in einer festen dritten vorbestimmten Position montiert ist; und
wobei der zweite Arn (12) vom ersten Arm (10) weggeschoben wird; das zweite Verbindungsglied (20) des zweiten Arms (12) vom ersten Verbindungsglied (18) des ersten Arms (10) weggeschoben wird; und die Kabelbasis (14) wegen der Schiebeleiste (30), die auf dem zweiten Trägerelement (26) gleitet, von der tragenden Basis (16) wegbewegt wird.

3. Der Aufbau des Kabelführungsarms nach Anspruch 1 oder 2, wobei das zweite Trägerelement (26) einen ersten Hemmschuh (58) und einen zweiten Hemmschuh (60) aufweist; die Position beider Hemmschuhe (58, 60) der Schiebeleiste (30) entspricht, so dass diese Schiebeleiste (30) zwischen dem ersten Hemmschuh (58) und dem zweiten Hemmschuh (60) gleiten kann; wobei mit der Schiebeleiste (30) nach deren Anschlagen an den ersten Hemmschuh (58) das zweite Trägerelement (26) zum Verschieben am ersten Trägerelement (24) anschiebt.

4. Der Aufbau des Kabelführungsarms nach Anspruch 1, wobei das erste Trägerelement (24) einen ersten Haken (54) und das zweite Trägerelement (26) einen zweiten Haken (56) aufweist; das Kunststoffelement (28) am ersten Haken (54) und am zweiten Haken (56) befestigt ist.

5. Der Aufbau des Kabelführungsarms nach Anspruch 2, wobei die tragende Basis (16) mit einem ersten Stützelement (38) und einem zweiten Stützelement (40) gebildet ist und letzteres senkrecht zum ersten Stützelement (38) angeordnet ist; das dritte Verbindungsglied (22) drehgelenkig am ersten Stützelement (38) befestigt ist; das erste Trägerelement (24) drehgelenkig am zweiten Stützelement (40) befestigt ist.

6. Der Aufbau des Kabelführungsarms nach Anspruch 5, wobei das erste Stützelement (38) der tragenden Basis (16) einen ersten Überstand (76) und einen zweiten Überstand (78) aufweist; das dritte Verbindungsglied (22) ein erstes Positionierloch (80) und ein zweites Positionierloch (82) aufweist; beim Rotieren des dritten Verbindungsgliedes (22) an der tragenden Basis (16) in eine erste Richtung (F1) und in eine erste Position der erste Überstand (76) des dritten Verbindungsgliedes (22) mit dem ersten Positionierloch (80) in Eingriff gebracht wird, um das dritte Verbindungsglied (22) in der Position zu befestigen; beim Rotieren des dritten Verbindungsgliedes (22) an der tragenden Basis (16) in eine zweite Richtung (F2) und in eine zweite Position der zweite Überstand (78) des dritten Verbindungsgliedes (22) mit dem zweiten Positionierloch (82) in Eingriff gebracht wird, um das dritte Verbindungsglied (22) in der Position zu befestigen.

7. Der Aufbau des Kabelführungsarms nach Anspruch 2, wobei das Plättchen (34) eine gebogene Schiebenut (36) aufweist und die Schiebeleiste (30) mit einem ersten Verbindungselement (33a) in dieser gebogenen Schiebenut (36) befestigt ist, um begrenzt in diesem Plättchen (34) zu rotieren.

8. Der Aufbau des Kabelführungsarms nach Anspruch 2, weiter umfassend:
einen ersten Gleitschienenaufbau (62), der eine erste feste Schiene (66) und eine erste verschiebbare Schiene (68) umfaßt, wobei letztere der Länge nach und gleitend in der ersten festen Schiene (66) verschoben werden kann; und
einen zweiten Gleitschienenaufbau (64), der eine zweite Schiene (70) und eine zweite verschiebbare Schiene (72) umfaßt, wobei letztere der Länge nach und gleitend in der zweiten festen Schiene (70) verschoben werden kann;
wobei das erste Verbindungsglied (18) an der ersten festen Schiene (66) des in der ersten vorbestimmten Position zu befestigenden ersten Gleitschienenaufbaus (62) montiert ist; das zweite Verbindungsglied (20) an der ersten verschiebbaren Schiene (68) des in der zweiten vorbestimmten Position zu befestigenden ersten Gleitschienenaufbaus (62) montiert ist; die zweite vorbestimmte Position beim Gleiten der ersten verschiebbaren Schiene (68) in der ersten festen Schiene (66) variabel ist; und das dritte Verbindungsglied (22) an der zweiten festen Schiene (70) des zweiten Gleitschienenaufbaus (64) montiert ist und in der dritten vorbestimmten Position zu befestigen ist.

9. Eine Kabelführungsvorrichtung mit einem Kabelführungsarm nach Anspruch 1, weiter umfassend:
einen ersten Gleitschienenaufbau (62), der eine erste feste Schiene (66) und eine erste verschiebbare Schiene (68) umfaßt; die erste verschiebbare Schiene (68) der Länge nach gleitbar in der ersten festen Schiene (66) montiert ist; und
einen zweiten Gleitschienenaufbau (64), der eine zweite feste Schiene (70) und eine zweite verschiebbare Schiene (72) umfaßt; die zweite verschiebbare Schiene (72) der Länge nach gleitbar in der zweiten festen Schiene (70) montiert ist; **dadurch gekennzeichnet, dass** die Kabelführungsvorrichtung weiter ein Kunststoffelement (28) umfaßt, das zwischen dem ersten Trägerelement (24) und dem zweiten Trägerelement (26) befestigt ist;
wobei der erste Arm (10) an der ersten festen Schiene (66) des ersten Gleitschienenaufbaus (62) befestigt ist; der zweite Arm (12) an der ersten verschiebbaren Schiene (68) des ersten Gleitschienenaufbaus (62) befestigt ist; die tragende Basis (16) an der zweiten festen Schiene (70) des zweiten Gleitschienenaufbaus (64) befestigt ist;
wobei beim Ausziehen des ersten Gleitschienenaufbaus (62) und des zweiten Gleitschienenaufbaus (64) der zweite Arm (12) vom ersten Arm (10) weggeschoben wird, die Schiebeleiste (30) durch Gleiten auf dem zweiten Trägerelement (26) von der tragenden Basis (16) wegbewegt wird, während die Schiebeleiste (30) das zweite Trägerelement (26) anschiebt, um dieses am ersten Trägerelement (24) auszuziehen, wobei das erste Trägerelement (24) bewegt wird, um dieses an der tragenden Basis (16) zu rotieren; und
wobei beim Einziehen des ersten Gleitschienenaufbaus (62) und des zweiten Gleitschienenaufbaus (64) der zweite Arm (12) nahe zum ersten Arm (10) gebracht wird, während das zweite Trägerelement (26) im ersten Trägerelement (24) als Reaktion auf eine mit dem Kunststoffelement (28) erzeugte elastische Kraft verschoben wird.

## Revendications

1. Un ensemble de bras de gestion de câbles comprenant :
un premier bras (10) ;
un second bras (12) ;
une base de câble (14) raccordée de façon pivotante entre le premier bras (10) et le second bras (12) ;
une plaque (34) raccordée de façon fixe à un fond de la base de câble (14) ; et
une base de support (16) ;
un premier élément de support (24) raccordé de façon pivotante à la base de support (16) et en butée contre la base de support (16) ;
un second élément de support (26) raccordé de façon mobile au premier élément de support (24) ; et
une base coulissante (30) raccordée à la plaque (34) et raccordée de façon mobile au second élément de support (26) ;
dans lequel lorsque le second bras (12) est déplacé à l'écart du premier bras (10), la base coulissante (30) se déplace à l'écart de la base de support (16) en coulissant sur le second élément de support (26), et la base coulissante (30) entraîne le second élément de support (26) pour se prolonger par rapport au premier élément de support (24) et entraîne le premier élément de support (24) à tourner par rapport à la base de support (16) ; **caractérisé en ce que** le second élément de support (26) est extensible et rétractable par rapport au premier élément de support (24), dans lequel un élément élastique (28) est raccordé entre le premier élément de support (24) et le second élément de support (26) de sorte que le second élément de support (26) peut être tiré de façon élastique par rapport au premier élément de support (24) par l'élément élastique (28).

2. L'ensemble de bras de gestion de câbles de la revendication 1, comprenant en outre :
une première unité de raccordement (18) raccordée au premier bras (10);
une deuxième unité de raccordement (20) raccordée au second bras (12) ; et
une troisième unité de raccordement (22) raccordée à la base de support (16) ;
dans lequel le premier bras (10) est monté dans une première position prédéterminée fixe via la première unité de raccordement (18) ; le second bras (12) est monté dans une seconde position prédéterminée variable via la deuxième unité de raccordement (20) ; et la base de support (16) est montée dans une troisième position prédéterminée fixe via la troisième unité de raccordement (22) ; et
dans lequel lorsque le second bras (12) est déplacé à l'écart du premier bras (10), la deuxième unité de raccordement (20) du second bras (12) est déplacée à l'écart de la première unité de raccordement (18) du premier bras (10), et la base de câble (14) est déplacée à l'écart de la base de support (16) du fait du coulissement de la base coulissante (30) sur le second élément de support (26).

3. L'ensemble de bras de gestion de câbles de la revendication 1 ou 2, dans lequel le second élément de support (26) présente un premier butoir (58) et un second butoir (60), les deux butoirs (58, 60) correspondant en position à la base coulissante (30) de sorte que la base coulissante (30) peut coulisser entre le premier butoir (58) et le second butoir (60) ; et la base coulissante (30), une fois arrêtée au premier butoir (58), entraîne le second élément de support (26) à se déplacer par rapport au premier élément de support (24).

4. L'ensemble de bras de gestion de câbles de la revendication 1, dans lequel le premier élément de support (24) présente un premier crochet (54), le second élément de support (26) présente un second crochet (56), et l'élément élastique (28) est raccordé au premier crochet (54) et au second crochet (56).

5. L'ensemble de bras de gestion de câbles de la revendication 2, dans lequel la base de support (16) présente une première partie de support (38) et une seconde partie de support (40) substantiellement perpendiculaire à la première partie de support (38), la troisième unité de raccordement (22) étant raccordée de façon pivotante à la première partie de support (38), le premier élément de support (24) étant raccordé de façon pivotante à la seconde partie de support (40).

6. L'ensemble de bras de gestion de câbles de la revendication 5, dans lequel la première partie de support (38) de la base de support (16) présente une première projection (76) et une seconde projection (78) ; la troisième unité de raccordement (22) présente un premier trou de positionnement (80) et un second trou de positionnement (82) ; lorsque la troisième unité de raccordement (22) est tournée dans une première direction (F1) par rapport à la base de support (16) dans une première position, la première projection (76) de la troisième unité de raccordement (22) est engagée dans le premier trou de positionnement (80) pour maintenir la troisième unité de raccordement (22) en position ; et lorsque la troisième unité de raccordement (22) est tournée dans une seconde direction (F2) par rapport à la base de support (16) vers une seconde position, la seconde projection (78) de la troisième unité de raccordement (22) est engagée dans le second trou de positionnement (82) pour maintenir la troisième unité de raccordement (22) en position.

7. L'ensemble de bras de gestion de câbles de la revendication 2, dans lequel la plaque (34) présente une rainure coulissante incurvée (36), et la base coulissante (30) est raccordée à la rainure coulissante incurvée (36) via un premier élément de raccordement (33a) de façon à tourner par rapport à la plaque (34) de manière limitée.

8. L'ensemble de bras de gestion de câbles de la revendication 2, comprenant en outre :
un premier assemblage de glissière (62) comprenant un premier rail fixe (66) et un premier rail mobile (68) déplaçable de façon longitudinale et coulissante par rapport au premier rail fixe (66) ; et
un second assemblage de glissière (64) comprenant un second rail fixe (70) et un second rail mobile (72) déplaçable de façon longitudinale et coulissante par rapport au second rail fixe (70) ;
dans lequel la première unité de raccordement (18) est montée sur le premier rail fixe (66) du premier assemblage de glissière (62) pour être fixée dans la première position prédéterminée ; la deuxième unité de raccordement (20) est montée sur le premier rail mobile (68) du premier assemblage de glissière (62) pour être située à la seconde position prédéterminée, la seconde position prédéterminée étant variable en fonction du coulissement du premier rail mobile (68) par rapport au premier rail fixe (66) ; et la troisième unité de raccordement (22) est montée sur le second rail fixe (70) du second assemblage de glissière (64) et pour être fixée dans la troisième position prédéterminée.

9. Un système de gestion de câbles comprenant l'ensemble de bras de gestion de câbles selon la revendication 1 et comprenant en outre :
un premier assemblage de glissière (62) comprenant un premier rail fixe (66) et un premier rail mobile (68), le premier rail mobile (68) étant coulissant longitudinalement par rapport au premier rail fixe (66) ; et
un second assemblage de glissière (64) comprenant un second rail fixe (70) et un second rail mobile (72), le second rail mobile (72) étant coulissant longitudinalement par rapport au second rail fixe (70) ; **caractérisé en ce que** le système de gestion de câbles comprend en outre un élément élastique (28) raccordé entre le premier élément de support (24) et le second élément de support (26) ;
dans lequel le premier bras (10) est raccordé au premier rail fixe (66) du premier assemblage de glissière (62) ; le second bras (12) est raccordé au premier rail mobile (68) du premier assemblage de glissière (62) ; et la base de support (16) est raccordée au second rail fixe (70) du second assemblage de glissière (64) ;
dans lequel lorsque le premier assemblage de glissière (62) et le second assemblage de glissière (64) sont prolongés, le second bras (12) est déplacé à l'écart du premier bras (10), la base coulissante (30) se déplace à l'écart de la base de support (16) en coulissant sur le second élément de support (26), et la base coulissante (30) entraîne le second élément de support (26) pour se prolonger par rapport au premier élément de support (24) et entraîne le premier élément de support (24) à tourner par rapport à la base de support (16) ; et
dans lequel lorsque le premier assemblage de glissière (62) et le second assemblage de glissière (64) sont rétractés, le second bras (12) est rapproché du premier bras (10), et le second élément de support (26) est déplacé par rapport au premier élément de support (24) en réponse une force élastique générée par l'élément élastique (28).
